## Europäisches Patentamt
## European Patent Office
## Office européen des brevets

(19)

(11) Veröffentlichungsnummer: **0 021 143**
**B1**

(12) **EUROPÄISCHE PATENTSCHRIFT**

(45) Veröffentlichungstag der Patentschrift:
25.05.83

(51) Int. Cl.³: **G 11 C 11/40**, G 11 C 11/24,
G 11 C 7/00

(21) Anmeldenummer: 80103080.0

(22) Anmeldetag: 03.06.80

(54) Verfahren und Schaltungsanordnung zur Selektion und Entladung von Bitleitungskapazitäten für einen hochintegrierten Halbleiterspeicher.

(30) Priorität: 28.06.79 DE 2926094

(43) Veröffentlichungstag der Anmeldung:
07.01.81 Patentblatt 81/1

(45) Bekanntmachung des Hinweises auf die Patenterteilung:
25.05.83 Patentblatt 83/21

(84) Benannte Vertragsstaaten:
DE FR GB

(73) Patentinhaber: International Business Machines
Corporation, Armonk, N.Y. 10504 (US)

(72) Erfinder: Heuber, Klaus, Taunusstrasse 62,
D-7030 Böblingen (DE)
Erfinder: Wiedmann, Siegfried, Dr., Im Himmel 64A,
D-7000 Stuttgart 80 (DE)

(74) Vertreter: Rudolph, Wolfgang, Schönaicher Strasse 220,
D-7030 Böblingen (DE)

(56) Entgegenhaltungen:
EP-A-0 013 302
FR-A-2 337 398
US-A-3 500 341
US-A-3 540 010
US-A-3 573 499
US-A-3 900 838
US-A-4 021 786
US-A-4 032 902
US-A-4 070 656
US-A-4 090 255
US-A-4 112 511
US-A-4 122 548

IEEE JOURNAL OF SOLID-STATE CIRCUITS, Band SC-2, Nr. 4, Dezember 1977, New York, US, J. E. IWERSEN et al.: »Beam-lead sealed-junction semiconductor memory with minimal cell complexity« Seiten 196—201
IEEE JOURNAL OF SOLID-STATE CIRCUITS, Band SC-6, Nr. 5, Oktober 1971, New York, US, HENN: »Bipolar dynamic memory cell« Seiten 297—300

IEEE JOURNAL OF SOLID-STATE CIRCUITS, Band SC-13, Nr. 5, Oktober 1978, New York, US, KAWARADA et al.: »A fast 7.5 ns access 1K-Bit RAM for cache-memory systems«, Seiten 656—663
IBM TECHNICAL DISCLOSURE BULLETIN, Band 22, Nr. 10, März 1980, New York, US, K. HEUBER et al.: »MTL storage array«, Seiten 4606—4607
IBM TECHNICAL DISCLOSURE BULLETIN, Band 21, Nr. 1, Juni 1978, New York, US, S. K. WIEDMANN: »MTL storage cell«, Seiten 231—232
IBM TECHNICAL DISCLOSURE BULLETIN, Band 17, Nr. 6, November 1974, New York, US, K. L. ANDERSON et al.: »Memory cell sensing scheme«, Seiten 1567—1568
IBM TECHNICAL DISCLOSURE BULLETIN, Band 13, Nr. 6, November 1970, New York, US, S. K. WIEDMANN: »Restore circuitry for Bit/sense system«, Seiten 1705—1706
EDN ELECTRICAL DESIGN NEWS, Band 13, Nr. 2, Februar 1968, New York, US, D. HILLIS: »Circuit design mates ECL and TTL«, Seiten 42—46

## Verfahren und Schaltungsanordnung zur Selektion und Entladung von Bitleitungskapazitäten für einen hochintegrierten Halbleiterspeicher

Die Erfindung betrifft ein Verfahren und eine Schaltungsanordnung zur Selektion und Entladung der Bitleitungskapazitäten für einen hochintegrierten Halbleiterspeicher, dessen Speicherzellen in Bipolar-Technik hergestellt sind, nach dem Oberbegriff des Patentanspruchs 1 bzw. 3.

Durch die DE-PS 2 511 518 sind ein Verfahren und eine Schaltungsanordnung zum Betreiben eines integrierten Halbleiterspeichers bekanntgeworden, dessen Speicherzellen aus Flip-Flops mit bipolaren Transistoren und Schottky-Dioden als Lese-/Schreib-Ankoppelelemente bestehen und die als Lastelemente hochohmige Widerstände oder als Stromquellen geschaltete Transistoren benützen, deren Schreib-/Lese-Zyklen jeweils in mehreren Phasen ablaufen und die durch Pegeländerungen auf Wortleitungen und Bitleitungen selektiert werden, die zum Erhöhen der Schreibgeschwindigkeit und der Lesegeschwindigkeit sowie zum Verringern der Verlustleistung die Entladung der Bitleitungen über die leitenden Speicherzellen-Transistoren vornehmen. Das Entladen der Bitleitungen über diese leitenden Speicherzellen-Transistoren erfolgt dabei nach Masse. Während der Lesephase des Speichers werden die Bitleitungen nur geringfügig umgeladen, so daß der Umladestrom, der durch die Speicherzelle fließt, dabei sehr klein ist.

In den letzten Jahren hat auf dem Gebiet der logischen Verknüpfungsschaltungen und der integrierten Halbleiterspeichertechnik mit bipolaren Transistoren eine rege Entwicklung stattgefunden, die unter der Bezeichnung MTL (Merged Transistor Logic) oder auch I²L (Integrated Injection Logic) Eingang in die Fachliteratur gefunden hat. Es wird hierzu beispielsweise auf die Aufsätze im IEEE Journal of Solid State Circuits, Band SC/7, Nr. 5, Oktober 1972, Seiten 340 bis 342 und 346 verwiesen. Entsprechende Vorschläge wurden auch in der US-PS 3 736 477 sowie in der weiteren US-PS 3 816 758 gemacht.

Diese Konzepte mit bipolaren Transistoren zeichnen sich durch kurze Schaltzeiten aus und sind zum Aufbau von extrem hochintegrierten Speichern und logischen Schaltungsverbänden besonders geeignet.

Aus der DE-OS 2 307 739 ist eine weitere Speicherzelle bekanntgeworden, die aus zwei logischen Schaltungen zusammengesetzt ist und bei der der Kollektor des invertierenden Transistors der einen Schaltung jeweils mit der Basis des invertierenden Transistors der anderen Schaltung gekoppelt ist. Die beiden Transistoren werden wiederum invers betrieben und bilden die eigentlichen Flip-Flop-Transistoren. Als Lastelement für beide Flip-Flop-Transistoren dient der über eine gesonderte Leitung angeschlossene komplementäre Transistor jeder Grundschaltung, über den die Injektion der Minoritätladungsträger, also die Stromversorgung erfolgt.

Zum Zwecke der Adressierung, d. h. zum Einschreiben und zum Lesen der Speicherzelle, ist zusätzlich die Basis jedes Flip-Flop-Transistors mit dem Emitter des zugeordneten zusätzlichen, ebenfalls komplementären Adressier-Transistors verbunden, dessen Kollektor an der zugeordneten Bitleitung und dessen Basis an der Adreßleitung liegt.

Da hier ein zusätzlicher Transistor vorhanden ist, wurde in der DE-OS 2 612 666 eine hochintegrierte, invertierende logische Schaltung mit einer, einen invertierenden Transistor bildenden Säulenfolge bekannt, der über ein Injektionsgebiet in der Nähe des Basis-Emitterübergangs durch Injektion von Ladungsträgern mit Betriebsstrom versorgt und an der Basis gesteuert wird, der dadurch gekennzeichnet ist, daß an das Injektionsgebiet eine Abfühlschaltung angeschlossen ist, über die der Leitzustand des invertierenden Transistors aufgrund des vom leitenden Transistors in das Injektionsgebiet rückinjizierten Stromes abgefühlt wird.

Speicher mit Speicherzellen, die eine MTL-ähnliche Struktur aufweisen, verlangen bei der Selektion einer Speicherzelle die Umladung von Bitdaten- und/oder Steuerleitungskapazitäten. Der Spannungshub der Bitleitungen entspricht dabei ungefähr dem Spannungshub der selektierten Wortleitungen.

Wie bereits in der DE-A-2 511 518 beschrieben ist, werden die kapazitiven Entladeströme über die Speicherzellen der selektierten Wortleitung und über den Wortleitungstreiber nach Masse abgeführt. Dies hat jedoch bei einer größeren Anzahl von Speicherzellen innerhalb einer Matrix den Nachteil, daß der Flächenbedarf der Treiberschaltkreise, die elektrische Verlustleistung für jeden Treiber und die Verzögerungszeit bei der Selektion der Wortleitung unverhältnismäßig groß werden, so daß die Vorteile der verwendeten MTL-Struktur dadurch wieder verloren gehen würden.

Um diesen Nachteil zu beseitigen, wurde bereits in der EP-A-0 013 302 (die zum Stand der Technik nach Artikel 54 (3) EPÜ gehört) ein Verfahren zum Betreiben eines Halbleiterspeichers und eine Schaltungsanordnung vorgeschlagen, die diese Nachteile nicht mehr aufweisen. Das genannte Verfahren ist dadurch charakterisiert, daß eine an sich bekannte Kontrollogik frühzeitig vor dem Selektieren für die Speichermatrix aufgrund eines Auswahlsignals gleichzeitig Steuersignale auf eine Entladeschaltung, die allen Speicherzellen gemeinsam ist, und auf Schalttransistoren abgibt, die daraufhin eingeschaltet werden, daß dadurch auf den Bitdaten- und -steuerleitungen die Entladeströme der Leitungskapazitäten durch die Schalttransistoren fließen und über die Entladeschaltung gemeinsam abfließen. Die genannte Schaltungsanordnung ist dadurch gekennzeichnet, daß die Bitleitungen innerhalb der Speichermatrix mit einer Entladeleitung verbunden sind, die ihrerseits mit einer Entladeschaltung verbunden ist und daß die Entladeschaltung und alle Wort- und/oder Bitleitungsschalttransistoren zur Steuerung über Leitungen mit einer Kontroll- oder Steuerlogik verbunden sind, die mit dem Selektionssignal des Speicherchips verbunden ist.

Obwohl es dieses Entladeverfahren sowie die Schaltungsanordnung zur Durchführung dieses Verfahrens gestatten, den minimalen Hub auf der Wortleitung zu verwenden, kapazitive Spitzenströme auf den Spannungsversorgungsleitungen zu verhindern und eine relativ hohe Integration erlauben, hat diese Lösung folgende Nachteile: Der Ablauf der Entladeoperation und der Selektionsoperation der Bitleitungen muß zeitlich nacheinander erfolgen. Der Anstieg des Abfühlstroms aus dem Abfühlschaltkreis nach der Selektion der Bitleitungen bestimmt mit maßgeblich die Zugriffszeit zur Speicherzelle. Die parallel arbeitenden Bit- und Wortleitungs-Schalttransistoren müssen am Ende der Selektionszeit alle eingeschaltet werden, so daß sich die Restorezeit des Speicherchips um die hierfür notwendige Zeit verlängert.

Außerdem ist aus dem IBM Technical Disclosure Bulletin, Bd. 17, Nr. 6, November 1974, Seiten 1567 und 1568 ein Ausleseverfahren für einen Speicher mit Feldeffekttransistoren bekannt, bei dem die Decodierung der Speicherzelle mit der Aktivierung der Wortleitung und damit mit der Entladung der Kapazitäten der Bitleitungen erfolgt. Dabei wird nur eine der beiden Bitleitungen entladen, und ein kapazitiver Entladestrom fließt über eine Kapazität zu einem Referenzpotential ab. Dieser Strom erhöht sich, weil eine Diode zu leiten beginnt und damit der Auslesestrom zwei Komponenten, nämlich eine erste durch den vom Leseschaltkreis gelieferten Strom und eine zweite durch den vom kapazitiven Entladestrom erzeugten Strom enthält. Da jedoch die Feldeffekttransistoren ein völlig anderes Betriebs- und Schaltverhalten als die bipolaren Transistoren aufweisen, ist dieses Verfahren nicht geeignet, auf die bipolare Speichertechnik übertragen zu werden.

Außerdem ist aus der US-PS 3 540 010 ein Halbleiterspeicher bekannt, dessen Speicherzellen aus Flip-Flops mit bipolaren Transistoren bestehen. Dieser Halbleiterspeicher enthält einen Lese-/Schreibschaltkreis, und die Leitungskapazitäten werden vor oder während einer Schreib- bzw. Leseoperation entladen. Bei der Leseoperation wird gemäß dieser Patentschrift der kapazitive Strom der selektierten Zelle zugeleitet, und zwar nur auf die Bitleitung, die mit der eingeschalteten Seite der Speicherzelle in Verbindung steht. Der kapazitive Strom fließt dann über die Speicherzelle und wird im Lese-/Schreibschaltkreis als Lesesignal wahrgenommen. Je nach Auslegung der Speicherzellen ist es möglich, den Speicher entweder nur mit Hilfe des von den Bitleitungskapazitäten bei der Selektion entstehenden dynamischen Strom zu lesen oder zusammen mit einem vom Lese-/Schreibschaltkreis gelieferten Treiberstrom. Obwohl hier bereits gezeigt ist, daß Halbleiterspeicher mit bipolaren Transistoren durch die von Bitleitungskapazitäten bei der Selektion erzeugten Ströme allein oder zusammen mit einem Treiberstrom vom Lese-/Schreibschaltkreis, der mit den Bitleitungen verbunden ist, gelesen werden können, hat dieses Selektionsverfahren den Nachteil, daß ein Schreiben mit Hilfe dieser kapazitiven Ströme nicht möglich ist und auch das Lesen auf höchstintegrierte Speicher mit wesentlich kleineren Spannungs- und Strompegel nicht ohne weiteres übertragen werden kann.

Der Erfindung liegt deshalb die Aufgabe zugrunde, ein Verfahren und eine Schaltungsanordnung zur Selektion und Entladung der Bitleitungskapazitäten für einen hochintegrierten Halbleiterspeicher, dessen Speicherzellen in Bipolar-Technik hergestellt sind, zu schaffen, wobei das zeitliche Nacheinander von Selektionsoperation und Entladeoperation beseitigt werden soll und das gemeinsame Abschalten der parallel arbeitenden Bit- und Wortleitungsschalttransistoren am Ende der Selektionszeit vermieden werden soll und bei dem die kapazitiven Entladeströme nicht nur zum Lesen, sondern auch zum Schreiben benutzt werden sollen, und zwar unter Berücksichtigung der sehr kleinen Nutzpegeländerungen in höchstintegrierten bipolaren Speicheranordnungen.

Die erfindungsgemäße Lösung der Aufgabe besteht im Kennzeichen des Patentanspruches 1.

Die erfindungsgemäße Schaltungsanordnung zur Durchführung des Verfahrens ist im Patentanspruch 3 charakterisiert. Weitere Ausgestaltungen der Schaltungsanordnung ergeben sich aus den Patentansprüchen 4 und 5.

Der Vorteil des vorgeschlagenen Entladeschemas besteht darin, daß bei sehr kleiner Zugriffs-/Zykluszeit im Nanosekundengebiet und ebenfalls sehr kleiner Verlustleistung im Milliwattgebiet für ein hochintegriertes MTL-Speicherchip kein großer Spitzenstrom auf den selektierten Wortleitungen WL beim Entladen auftritt und daß dadurch, daß die Entladung der Bitleitungskapazitäten parallel zur Selektion der Wortleitung verläuft und das selektierte Bitleitungspaar durch die selektierte Speicherzelle zur Wortleitung hin entladen wird, sich die Zeiten für die Selektionsoperation und für die Entladeoperation nicht addieren, sondern lediglich überlagern und daß sich dadurch die Lese-/Schreib-Operation beschleunigt. Eine Erhöhung der Arbeitsgeschwindigkeit, d. h. eine Verringerung der Zugriffszeit des Speicherchips ist die Folge. Außerdem wird der Spannungshub der Bitleitungsentladung nur durch den restspannungsgesteuerten Entladeschalter bestimmt. Für die Selektion einer Speicherzelle innerhalb des Speicherarrays werden nur die Bitleitungsschalttransistoren decodiert abgeschaltet, die an dem selektierten Bitleitungspaar angeschlossen sind. Die Bitleitungsschalttransistoren, die an den anderen nicht selektierten Bitleitungspaaren angeschlossen sind, bleiben auch während der Selektionsphase leitend. Auf der Wortseite wird ebenfalls nur der Wortleitungsschalttransistor abgeschaltet, der an die selektierte Wortleitung angeschlossen ist. Durch die Anwendung dieses decodierten Schaltens der Entladetransistoren mit den dazugehörigen Wort- und Bitdecoderschaltkreisen ist unter Einsatz minimalen Schaltungsaufwands eine Decodierung der Entladetransistoren möglich.

Die Erfindung wird nun anhand von in den Zeichnungen dargestellten Ausführungsbeispielen näher beschrieben.

Es zeigt:

Fig. 1 ein Speicherchip im Ruhezustand mit den erforderlichen Schaltern,

Fig. 2 das Speicherchip nach Fig. 1 bei Anlegen bestimmter Wort- und Bitselektionssignale,

Fig. 3 das Speicherchip nach Fig. 1 mit aktiviertem Entladeschalter,

Fig. 4 das Speicherchip nach Fig. 1 mit selektierter Wortleitung,

Fig. 5 ein Diagramm, in dem der zeitliche Verlauf des Abfühlstroms für die selektierte Speicherzelle des Speicherchips nach den Fig. 1 bis 4 dargestellt ist,

Fig. 6 eine Schaltung zur Selektion und Entkopplung einer Wortleitung und

Fig. 7 eine Schaltung des Entladeschaltkreises.

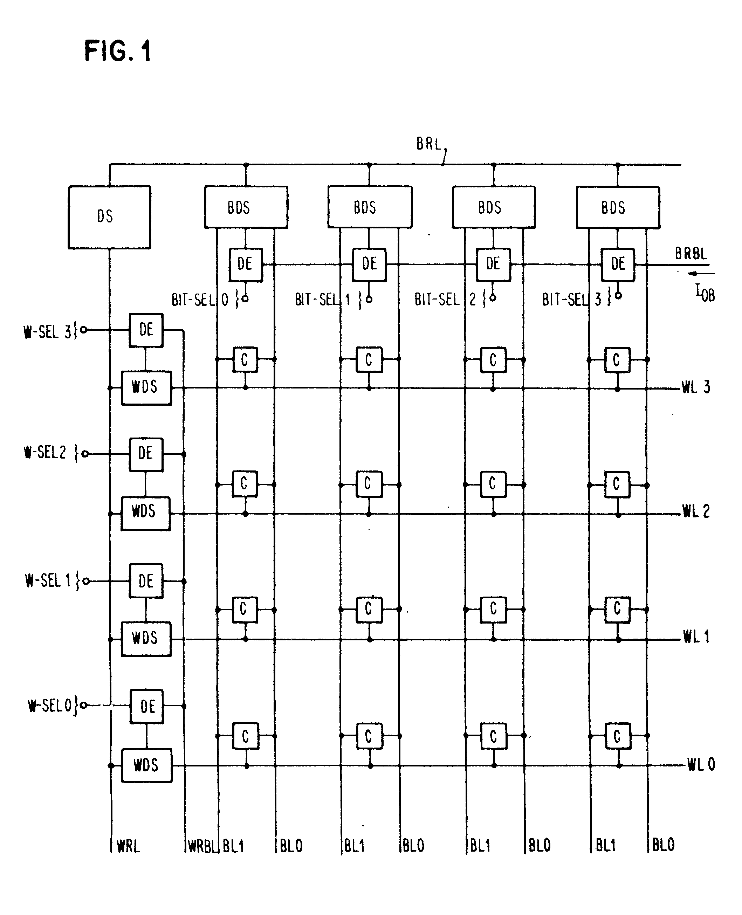

Das in Fig. 1 dargestellte Speicherchip weist in den Kreuzungspunkten von Wortleitungen WL und Bitleitungspaaren, wie BL1, BL0, MTL-Speicherzellen C auf. Jedes Bitleitungspaar BL1, BL0, an dem alle Speicherzellen innerhalb einer Spalte des Speichers liegen, ist mit einem Bitentladeschalter BDS verbunden, der seinerseits über ein Entkopplungselement DE angesteuert wird, an dessen Eingang des Bitselektionssignal BIT-SEL 0, 1, . . . und an der anderen Seite ein Strom IOB über die Bitreferenzbasisleitung BRBL anliegt. Außerdem sind alle Bitentladeschalter BDS innerhalb des Speicherverbands mit einer gemeinsamen Bitreferenzleitung BRL verbunden, die zu einem Bitentladeschalter DS führt. Der andere Eingang des Bitentladeschalters DS ist mit einer Wortreferenzleitung WRL verbunden. Zwischen jeder Wortleitung WL 0, 1, . . . und der genannten Wortreferenzleitung WRL liegt ein Wortentladeschalter WDS.

Jeder der Wortentladeschalter WDS ist mit einem der Entkopplungselemente DE verbunden, an deren Eingängen die Wortselektionssignale W-SEL 0, 1, . . . anliegen.

Bevor nun die einzelnen Phasen der Selektions- und Entladeoperation anhand des Schaltbilds nach Fig. 1 detailliert erklärt werden, soll im nachfolgenden das grundsätzliche des vorliegenden Selektions- und Entlade-Verfahrens beschrieben werden.

Das Selektionsverfahren benutzt für die Entladung der vorhandenen, nicht eingezeichneten Bitleitungskapazitäten die Bitleitungsschalttransistoren BDS, die von den Bitleitungen BL0 bzw. BL1 auf eine Bitentladeleitung BRL geschaltet sind und Wortleitungsschalttransistoren WDS, die an eine gemeinsame Wortreferenzleitung WRL angeschlossen sind.

Der Entladestrom der Bitleitungen BL1 und BL0 fließt über die Bit- und Wortleitungsschalttransistoren BDS und WDS und über den Bitentladeschalter DS, der zwischen der gemeinsamen Bitreferenzleitung BRL und der gemeinsamen Wortreferenzleitung WRL liegt. Der Spannungshub der Bitleitungsentladung wird durch den restspannungskontrollierten Bitentladeschalter DS bestimmt.

Für die Selektion einer Zelle C aus dem Speicherverband werden nur die Bitleitungsschalttransistoren BDS decodiert abgeschaltet, die an dem jeweils selektierten Bitleitungspaar angeschlossen sind. Diejenigen Bitleitungsschalttransistoren BDS, die an den anderen nicht selektierten Bitleitungspaaren angeschlossen sind, bleiben auch während der Selektionsphase leitend. Bei einem Speicher mit 128 Bitleitungspaaren, bei dem ein Bit selektiert wird, bedeutet dies, daß nur die Bitleitungsschalttransistoren für die Bitleitungspaare BL1, BL0 decodiert abgeschaltet werden, aus denen gelesen wird, während die restlichen Bitleitungsschalttransistoren für die anderen 127 Bitleitungspaare BL1, BL0, während der Selektionsphase leitend bleiben.

Auf der Wortseite wird ebenfalls nur der Wortleitungsschalttransistor WDS abgeschaltet, der an die selektierte Wortleitung WL angeschlossen ist. Damit ist die Selektion dieser Wortleitung WL möglich. Die Wortleitungsschalttransistoren, die an die nicht selektierten Wortleitungen WL angeschlossen sind, bleiben leitend. Das heißt, daß bei z. B. 128 vorhandenen Wortleitungen die Wortleitungsschalttransistoren für 127 nicht selektierte Wortleitungen leitend bleiben.

Die Anwendung dieses decodierten Schaltens der Entladetransistoren erlaubt mit den dazugehörigen Wort- und Bitdecoderschaltkreisen einen minimalen Aufwand an zusätzlichen Schaltungskomponenten und eine schnelle und einfache Decodierung der Entladetransistoren.

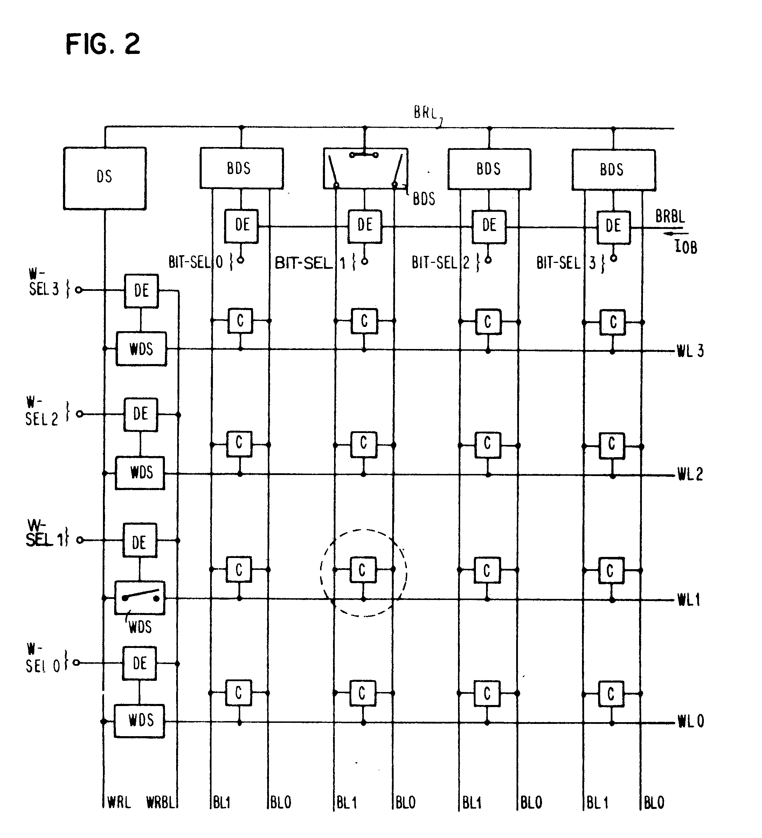

Innerhalb des in Fig. 2 dargestellten Speichers wird z. B. die eingekreiste Speicherzelle C durch Anlegen eines Signals auf der Wortleitung WL1 und durch Anlegen des Bitselektionssignals Bit-SEL1 am Eingang des betreffenden Entkopplungselement DE bewirkt. Es soll hier noch erwähnt werden, daß im Ruhezustand nur der Ruhezustandsstrom durch die Speicherzellen C fließt. Wie aus dem Prinzipschaltbild nach Fig. 2 zu sehen ist, werden durch Anlegen der Bitselektions- und Wortselektionssignale die Bit- und Wortentladeschalter BDS und WDS von den entsprechenden Referenzleitungen BRL und WRL getrennt bzw. entkoppelt. Um dies klar zu zeigen, wurde schematisch sowohl im zur Wortleitung WL1 zugehörigen Wortentladeschalter WDS als auch im zum Bitleitungspaar 1 gehörigen Bitentladeschalter BDS für jede Leitung ein zugehöriger offener Schalter eingezeichnet, der in der tatsächlichen Schaltung jedoch durch Transistoren verwirklicht wird.

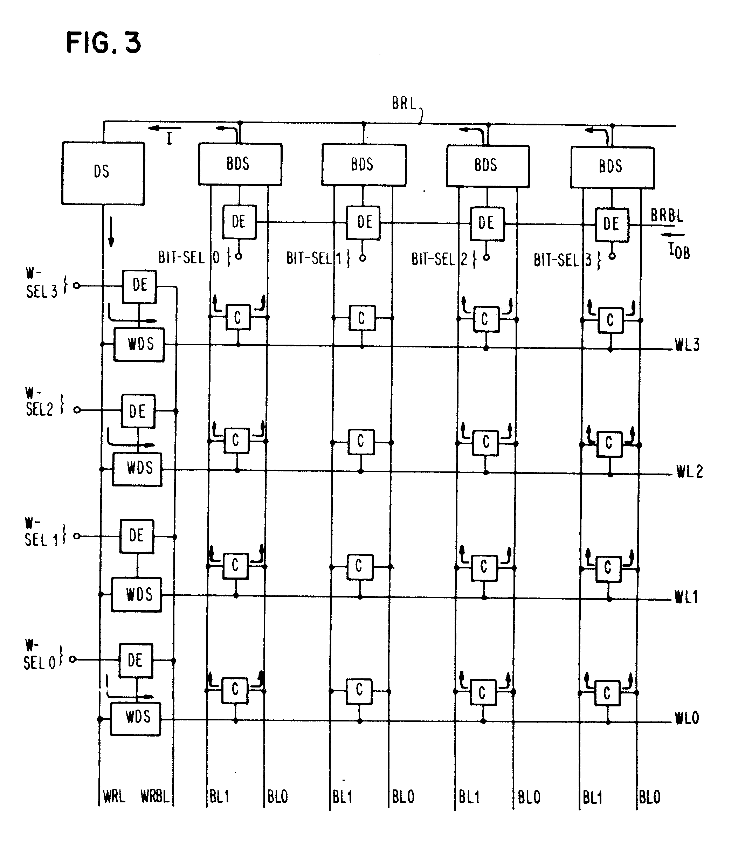

Wie nun aus Fig. 3 zu sehen ist, werden dann bei aktiviertem Entladeschalter DS alle Injektorkapazitäten der Bit-seitig nicht selektierten Speicherzellen C über die gemeinsame Bitreferenzleitung BRL entladen, was durch die eingezeichneten Pfeile in den Bitleitungspaaren BL1, BL0 und am Ausgang der Bitentladeschalter BDS schematisch gezeigt werden soll.

Der Entladestrom fließt jetzt über den Entladeschalter DS auf die gemeinsame Wortreferenzleitung WRL, über die nicht abgeschalteten Wortentladeschalter WDS in die betreffenden Wortleitungen WL und von da in die Speicherzellen C der nicht selektierten Bitleitungspaare, wie durch die entsprechenden Pfeile in Fig. 3 gezeigt ist.

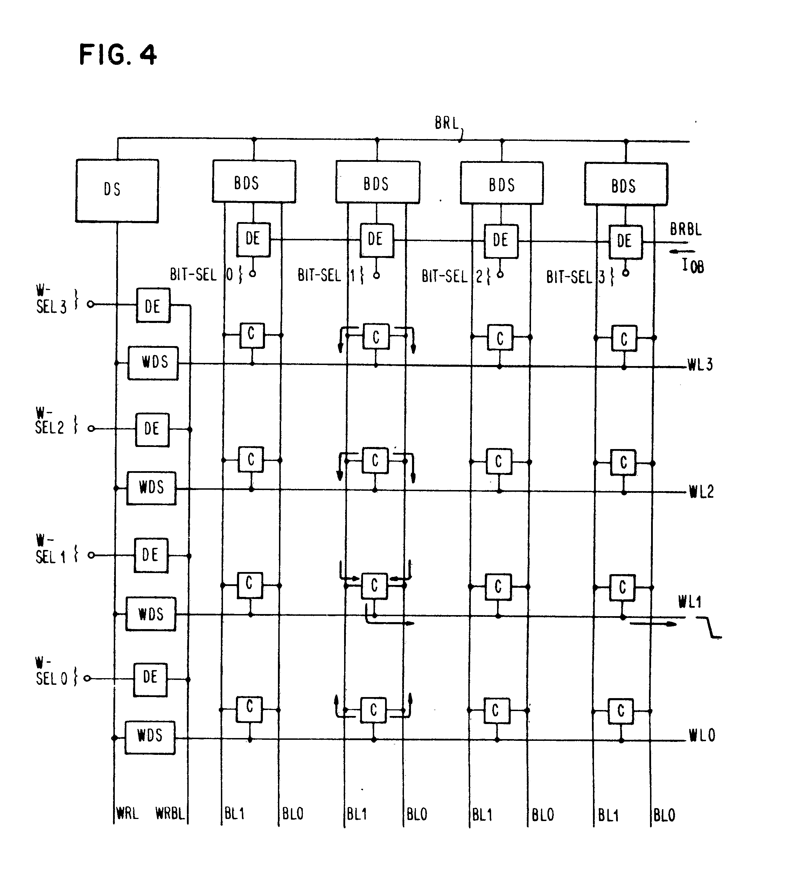

Wie nun aus Fig. 4 zu sehen ist, entladen sich beim Selektieren der Wortleitung WL1 (Absenken des Potentials auf der Wortleitung WL1, wie in Fig. 4 rechts dargestellt) die Injektorkapazitäten der Bit-seitig selektierten Speicherzelle C über diese Speicherzelle, wie durch die entsprechenden Pfeile im Bitleitungspaar 1 und auf der Wortleitung WL1 angezeigt ist. Es soll nochmals erwähnt werden, daß die in den Fig. 3 und 4 dargestellten Teiloperationen zeitlich parallel erfolgen.

Dadurch wird erreicht, daß der kapazitive Strom die selektierte Speicherzelle sehr schnell auf die zum Lesen oder Schreiben erforderlichen Werte hochbringt, so daß sehr frühzeitig ein großer Abfühlstrom für die Speicherzelle trotz langsam hochgehendem DC-Abfühl-Strom vorhanden ist.

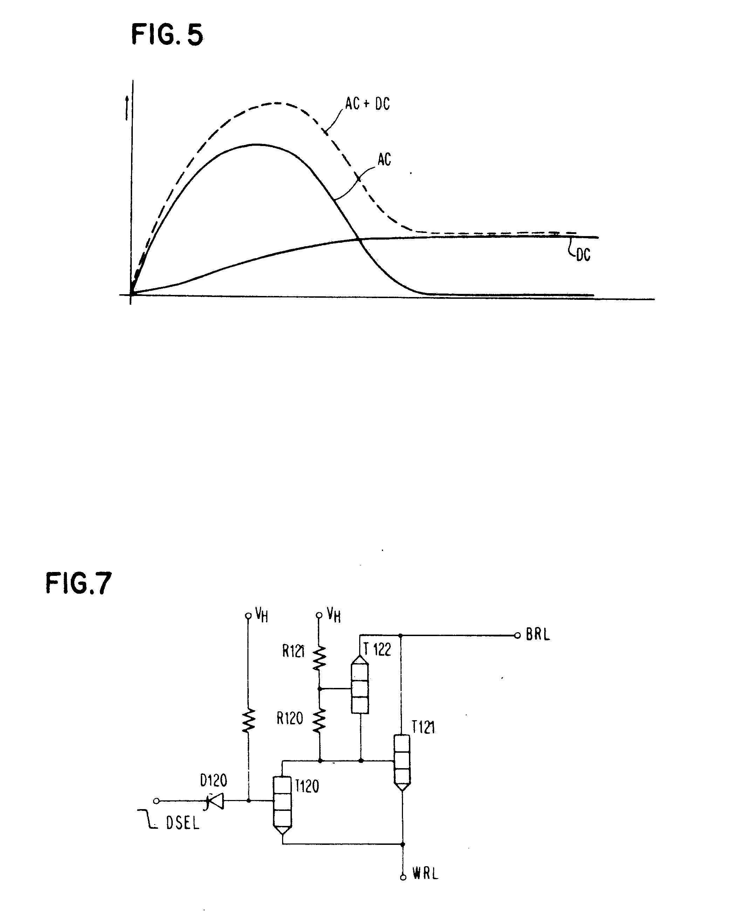

Die Überlagerung des Abfühlstrom aus dem Lese-/Schreibschaltkreis mit dem zeitlich früheren kapazitiven Abfühlstrom geht klar aus dem Stromdiagramm nach Fig. 5 hervor. Hier ist gezeigt, daß der vom Schreib-/Leseschaltkreis gelieferte Abfühlstrom DC nach dem Signal Bit-SEL zur Bitselektion hier nur langsam ansteigt, da er im Ausführungsbeispiel durch laterale PNP-Transistoren erzeugt wird. Hingegen fließt durch die Entladung der Bitleitungskapazitäten ein kapazitiver Strom AC durch die Koppel-PNP-Transistoren der Speicherzelle C, der dem vom Schreib-/Leseschaltkreis gelieferten Strom DC überlagert ist, d. h., daß er ihn unterstützt, so daß der gesamte Abfühlstrom sich aus der Addition des hochgehenden Gleichstroms und des kapazitiven Entladestroms addiert. Daraus ergibt sich eine wesentliche Verbesserung der Lese-/Schreibgeschwindigkeit ohne zusätzliche elektrische Verlustleistung. Außer der kürzeren Zugriffszeit vereinfachen sich die Zeitbedingungen für die einzelnen Steuersignale innerhalb des Speichers, da die Bitleitungskapazitäten-Entladung parallel zur Wortselektion erfolgt und nicht vorher abgeschlossen werden muß. Da außerdem nur einer von n Wortleitungsschalt-Transistoren bei einer Selektion aus- und wieder eingeschaltet werden muß, werden nur zwei von n Bitleitungsschalt-Transistoren bei einer Selektion aus- und wieder eingeschaltet. Daraus ergibt sich eine Einsparung an Schaltzeit und elektrischer Verlustleistung, wodurch die zusätzlich erforderliche Verlustleistung für die Decodierung der Schalttransistoren mindestens kompensiert wird.

Während dabei der kapazitive Abfühlstrom durch die dynamischen Vorgänge, die Größe der Bitleitungskapazitäten und den Spannungshub auf den Leitungen bestimmbar ist, ist der vom Lese-/Schreibverstärker gelieferte Strom je nach verwendeter Speicherzelle und Auslegung der verwendeten Speicherzelle getrennt über die Lese-/Schreibschaltkreise einstellbar.

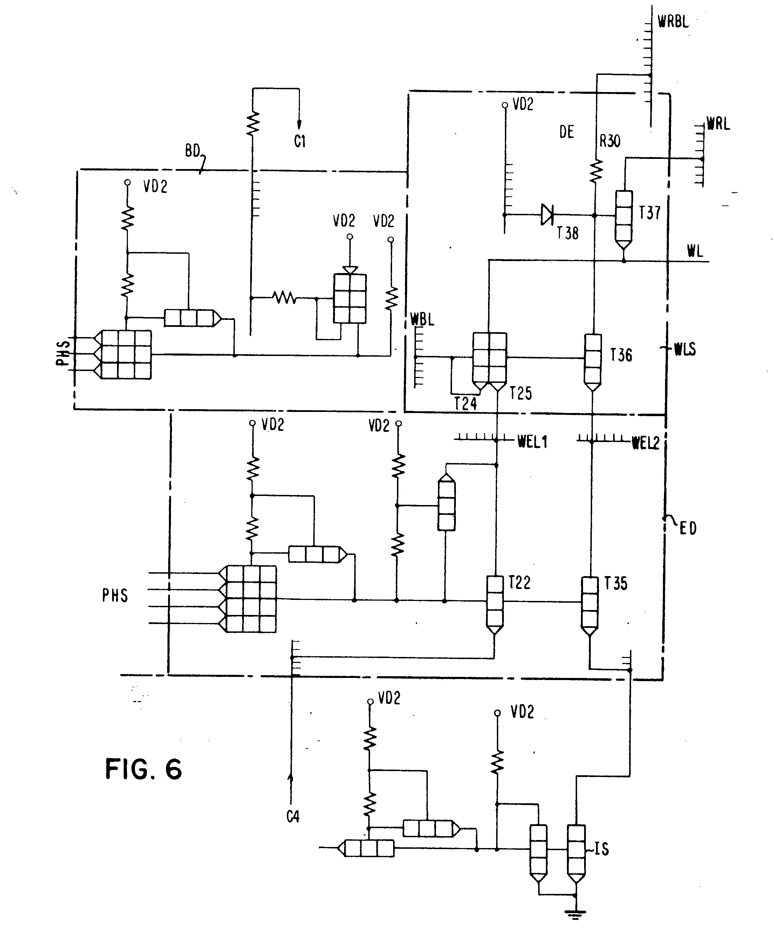

Eine Schaltungsanordnung, die eine Wortleitung WL selektieren kann und zusätzlich noch vorher ein Selekt-Signal für den Wortleitungsschalttransistor (z. B. T37) bereitstellt, ist in Fig. 6 gezeigt. Die verzögerte Selektion des Wortleitungstreibertransistors (T24 und T25) wird von dieser Schaltung ebenfalls erledigt. Ein nur teilweise dargestellter Taktgenerator im unteren Teil der Fig. 6 steuert den zeitlichen Ablauf der Schaltvorgänge auf dem Chip. Die Takte 1 und 2 werden dabei an die nicht dargestellten, dem Basis- und dem Wortdecodierer BD + ED vorgeschalteten Phasensplitter PHS gegeben. Der Takt 3 steuert die Bitselektion (BIT-SEL in Fig. 1 bis 4) des MTL-Speicherchips.

Nach dem Takt 2 sind die Ausgangssignale der Phasensplitter, die auf die Eingänge des Basis- und des Emitterdecoders BD und ED gegeben werden, im wahren Zustand. Darauf wird die Stromsenke 15 für die Entladung in die Bitleitung eingeschaltet, und danach wird der Transistor T35 im selektierten Emitterdecoder ED leitend und über den selektierten Basisdecodierer BD wird einer der n Transistoren T36 eingeschaltet.

Das Basispotential des ausgewählten Transistors T37 wird abgesenkt, und damit wird dieser gesperrt. Die Entkopplung der übrigen Transistoren T37 erfolgt durch den Widerstand R30. Die Stromquelle IS im Taktgenerator muß so ausgelegt sein, daß noch ein Reststrom über die Klemm-Diode T38 geliefert wird.

Über den nicht leitenden Transistor T37 ist die zu selektierende Wortleitung WL von der Wortreferenzleitung WRL entkoppelt. Jetzt kann die Selektion der Wortleitung WL erfolgen. Durch den Takt C4 wird der Transistor T22 im selektierten Emitterdecodierer ED eingeschaltet und über den selektierten Basisdecodierer BD wird der zur gleichen Wortleitung WL gehörige Wortleitungstreibertransistor T24, T25 eingeschaltet, wodurch die Wortleitung WL vom Ruhepotential auf das Selektionspotential entladen wird.

Der Entladeschalter DS ist in Fig. 7 detailliert dargestellt. Dieser Entladeschalter DS besteht aus einem Treibertransistor T121 und einem Klemm-Transistor T122, womit über das Widerstandsteilerverhältnis der Widerstände R120 und R121 die Restspannung für den eingeschwungenen Entladezustand eingestellt wird. Es wird bemerkt, daß die volle Entladung auf die Transistorrestspannung des Transistors T121 nicht erforderlich ist, dies würde nämlich nur die Ladung vergrößern, die beim Entladevorgang bewegt wird. Der Transistor T120 und die Diode D120 in der Schaltung nach Fig. 7 werden durch das Entladeselektions-Signal DS angesteuert und steuern ihrerseits den Entladetransistor T121.

Als Lese-/Schreibverstärker können bekannte Schaltungen verwendet werden. Da diese jedoch nicht Gegenstand der Erfindung sind, werden auch keine detaillierten Schaltungen hierfür angegeben. Die Wirkungsweise der Erfindung wird durch den Lese-/Schreibschaltkreis ebenfalls nicht beeinflußt.

Es ist selbstverständlich auch möglich, andere Decoderschaltungen wie die gezeigten zu verwenden, ohne daß das Prinzip der vorliegenden Erfindung verlassen wird.

**Patentansprüche**

1. Verfahren zur Selektion und Entladung der Bitleitungskapazitäten für einen hochintegrierten Halbleiterspeicher, dessen Speicherzellen (C) in Bipolar-Technik hergestellt sind, die in Kreuzungspunkten von Wort- und Bitleitungen (WL, BL) angeordnet sind und über Decodierer und Wortleitungstreiber selektiert werden, wobei die Bit- und Wortdecodierung nahezu parallel erfolgt und die Bitleitungskapazitäten bei der Selektion zum dynamischen Lesen einen Strom erzeugen, der der selektierten Speicherzelle zugeleitet wird, dadurch gekennzeichnet, daß gleichzeitig mit Beginn der Decodierung einer Speicherzelle (C) ein Schreib-/Leseschaltkreis initiiert wird und der zugehörige Bitleitungsschalter (BDS) decodiert abgeschaltet wird, wodurch das zu selektierende Bitleitungspaar (BL0, BL1) von einer für alle Bitleitungspaare gemeinsamen als Bitentladeleitung dienenden Bitreferenzleitung (BRL) getrennt wird, und daß gleichzeitig der Entladestrom der Bitleitungskapazitäten der nicht selektierten Bitleitungen über die Bit- und über Wortleitungsschalter (BDS, WDS), die an der Bit- und Wortreferenzleitung (BRL, WRL) angeschlossen sind, nach einem Referenzpotential abfließt, wodurch das Schreiben der Speicherzellen (C) mit dem Entladestrom erfolgt, der durch die Entladung der Kapazitäten des selektierten Bitleitungspaares (BL0, BL1) erzeugt wird, und wodurch beim Lesen der Entladestrom auf den Bitleitungen (BL1, BL0) eine Potentialdifferenz erzeugt, die im Lese-/Schreibschaltkreis zum Lesesignal verstärkt wird.

2. Verfahren nach Anspruch 1, dadurch gekennzeichnet, daß die Entladung der Bitleitungskapazitäten parallel zur Selektion der Wortleitung (WL) verläuft und daß das selektierte Bitleitungspaar (BL0, BL1) durch die selektierte Speicherzelle zur Wortleitung (WL) hin entladen wird, daß nur der Bitleitungsschalter (BDS) decodiert wird, der an dem selektierten Bitleitungspaar (BL0, BL1) angeschlossen ist, und daß auch nur der Wortleitungsschalter (WDS) abgeschaltet wird, der an die selektierte Wortleitung (WL) angeschlossen ist, während die nicht selektierten Bitleitungs- und Wortleitungsschalter (BDS und WDS) eingeschaltet bleiben.

3. Schaltungsanordnung zur Durchführung des Verfahrens nach den Ansprüchen 1 bis 2, dadurch gekennzeichnet, daß jede Wortleitung (WL) des Speichers mit einem Wortentladeschalter (WDS) verbunden ist, daß jedes Bitleitungspaar (BL0, BL1) mit einem Bitentladeschalter (BDS) verbunden ist, daß die Wortentladeschalter (WDS) mit einer gemeinsamen Wortreferenzleitung (WRL) verbunden sind, die ihrerseits als gemeinsame Entladeleitung dient und mit einem Entladeschalter (DS) verbunden ist, der seinerseits über eine Bitreferenzleitung (BRL), die als Bitentladeleitung dient, mit den Bitentladeschaltern (BDS) verbunden ist, und daß die Bitleitungspaare (BL0, BL1) mit einem Lese-/Schreibschaltkreis verbunden sind, wobei zum Schreiben und Lesen sowohl der Wortentladeschalter (WDS) der selektierten Wortleitung (WL) als auch der Bitentladeschalter (BDS) des selektierten Bitleitungspaares (BL0, BL1) geöffnet werden, um die Wortleitung und das Bitleitungspaar von der Wortreferenzleitung (WRL) und der Bitreferenzleitung (BRL) zu trennen.

4. Schaltungsanordnung nach Anspruch 3, dadurch gekennzeichnet, daß sowohl den Wortentladeschaltern (WDS) als auch den Bitentladeschaltern (BDS) Entkoppelelemente (DE) vorgeschaltet sind, die über eine Wortreferenzbasisleitung (WRBL) und über eine Bitreferenzbasisleitung (BRDL) bzw. über Wortselektionsleitungen (W-SEL) bzw. Bitselektionsleitungen (BITSEL) angesteuert werden.

5. Schaltungsanordnung nach Anspruch 4, dadurch gekennzeichnet, daß die Wortentladeschalter (WDS) zur Entkopplung der mit ihnen verbundenen Wortleitung (WL) mit der Wortreferenzleitung (WRL) und die Bitentladeschalter (BDS) zur Entkopplung eines Bitleitungspaares (BL1, BL0) von der gemeinsamen Bitreferenzleitung (BRL) dienen.

**Claims**

1. Method for selecting and discharging the bit line capacitances for a highly integrated semiconductor memory whose memory cells (C) are made in bipolar technique, which are arranged in intersections of word and bit lines (WL, BL), and which are selected via decoders and word line drivers, the bit and word decoding taking place almost in parallel, and the bit line capacitances generating upon the selection for dynamic reading a current which is applied to the selective memory cell, characterized in that simultaneously with the beginning of the memory cell decoding (C) a read/write circuit is initiated, and the associated bit line switch (BDS) is switched off in a decoded manner so that the bit line pair to be selected (BL0, BL1) is separated from a bit reference line (BRL) jointly used as bit discharge line by all bit line pairs, and that simultaneously the discharge current of the bit line capacitances of the non-selected bit lines flows to a reference potential via the bit and word line switches (BDS, WDS) connected to the bit and word reference line (BRL, WRL), so that the writing of the memory cells (C) is effected with the discharge current generated through the discharge of the capacitances of the selected bit line pair (BL0, BL1), and so that during reading the discharge current generates on the bit lines (BL1, BL0) a potential difference amplified in the read/write circuit to the read signal.

2. Method as claimed in claim 1, characterized in that the discharge of the bit line capacitances takes place in parallel to the selection of the word line (WL), and that the selected bit line pair (BL0, BL1) is discharged through the selected memory cell toward the word line (WL), that only that bit line switch (BDS) is decoded which is connected to the selected bit line pair (BL0, BL1), and that only that word line switch (WDS) is switched off which is connected to the selected word line (WL), whereas the non-selected bit line and word line switches (BDS and WDS) remain in the on-state.

3. Circuit arrangement for carrying out the method as claimed in claims 1 to 2, characterized in that each word line (WL) of the memory is connected to a word discharge switch (WDS), but each bit line pair (BL0, BL1) is connected to a bit discharge switch (BDS), that the word discharge switches are connected to a common word reference line (WRL) which in turn is used as a common discharge line and which is connected to a discharged switch (DS) which in turn is connected via a bit reference line (BRL) used as a bit discharge line, to the bit discharge switches (BDS), and that the bit line pairs (BL0, BL1) are connected to a read/write circuit, the word discharge switch (WDS) of the selected word line (WL) as well as the bit discharge switch (BDS) of the selected bit line pair (BL0, BL1) being opened for writing and reading, in order to separate the word line and the bit line pair from the word reference line (WRL) and from the bit reference line (BRL).

4. Circuit arrangement as claimed in claim 3, characterized in that the word discharge switches (WDS) as well as the bit discharge switches (BDS) have associated decoupling elements (DE) which are controlled via a word reference base line (WRBL) and via a bit reference base line (BRDL), and via word selection lines (W-SEL) or bit selection lines (BIT-SEL).

5. Circuit arrangement as claimed in Claim 4, characterized in that the word discharge switches (WDS) are used to decouple the word line (WL) connected thereto from the word reference line (WRL), and the bit discharge switches (BDS) to decouple a bit line pair (BL1, BL0) from the common bit reference line (BRL).

**Revendications**

1. Procédé de sélection et de décharge des capacités de lignes de bits d'une mémoire à semi-conducteurs à haute intégration dont les cellules de mémoire (C) sont réalisées en technique bipolaire, sont disposées aux points d'intersection des lignes de mots et des lignes de bits (WL, BL) et sont sélectionnées au moyen de décodeurs et d'excitateurs de lignes de mots, le décodage de bits et de mots s'effectuant sensiblement en parallèle, et les capacités des lignes de bits produisant, lors de la sélection pour la lecture dynamique, un courant qui est appliqué à la cellule de mémoire sélectionnée, ce procédé étant caractérisé en ce que, simultanément avec le début du décodage d'une cellule de mémoire (C), il y a initialisation d'un circuit d'écriture/lecture et mise hors tension du commutateur de ligne de bits correspondant (BDS), ce qui entraîne la séparation de la paire de lignes de bits à sélectionner (BL0, BL1) d'une ligne de référence de bit (BRL) servant de ligne de décharge de bit commune à toutes les paires de lignes de bits, et en ce que, simultanément, le courant de décharge des capacités des lignes de bits non sélectionnées s'écoule en fonction d'un potentiel de référence par l'intermédiaire des commutateurs de bits et de mots (BDS, WDS) reliés à la ligne de référence de bits et de mots (BRL, WRL), de telle sorte que l'écriture des cellules de mémoire (C) est effectuée au moyen du courant de décharge produit par le déchargement des capacités de la paire de lignes de bits sélectionnée (BL0, BL1), et de telle sorte que, lors de la lecture, le courant de décharge engendre, sur les lignes de bits (BL0, BL1), une différence de potentiel qui sera amplifiée en signal de lecture dans le circuit de lecture/écriture.

2. Procédé selon la revendication 1, caractérisée par le fait que la décharge des capacités des lignes de bits s'effectue parallèlement à la sélection de la ligne de mots (WL) et que la paire de lignes de bits sélectionnée (BL0, BL1) est déchargée vers la ligne de mots (WL) par l'intermédiaire de la cellule de mémoire sélectionnée, par le fait que seul est décodé le commutateur de ligne de bits (BDS) qui est relié à la paire de lignes de bits sélectionnée (BL0; BL1) et par le fait que seul est mis hors tension le commutateur de ligne de mots (WDS) qui est relié à la ligne de mots WL sélectionnée, cependant que les commutateurs de lignes de mots et de lignes de bits (BDS et WDS) non sélectionnés restent sous tension.

3. Circuit pour exécuter le procédé défini dans la revendication 1 ou 2 caractérisé par le fait que chaque ligne de mots (WL) de la mémoire est reliée à un commutateur de décharge de mot (WDS), par le fait que chaque paire de lignes de bits (BL0, BL1) est reliée à un commutateur de décharge de bit (BDS), par le fait que les commutateurs de décharge de mots (WDS) sont reliés à une ligne de référence de mots commune (WRL) qui sert de ligne de décharge commune et qui est reliée à un commutateur de décharge (DS) qui est lui-même relié, au moyen d'une ligne de référence de bits (BRL) qui sert de ligne de décharge de bits, aux commutateurs de décharge de bits (BDS) et par le fait que les paires de lignes de bits (BL0, BL1) sont reliés à un circuit de lecture/écriture, le commutateur de décharge de mots (WDS) de la ligne de mots sélectionnée (WL) et le commutateur de décharge de bits (BDS) de la paire de lignes de bits sélectionnée (BL0, BL1) étant ouverts, pour l'écriture comme pour la lecture, pour séparer la ligne de mots et la paire de lignes de bits de la ligne de référence de mots (WRL) et de la ligne de référence de bits (BRL).

4. Circuit selon la revendication 3 caractérisé en ce que les commutateurs de décharge de mots (WDS) ainsi que les commutateurs de décharge de bits (BDS) sont associés à des éléments de découplage (DE) montés en amont, et commandés par l'intermédiaire d'une ligne de base de référence de mot (WRBL) et d'une ligne de base de référence de bit (BRDL) et par l'intermédiaire de lignes de sélection de mots (W-SEL) ou de lignes de sélection de bits (BIT-SEL).

5. Circuit selon la revendication 4 caractérisé par le fait que les commutateurs de décharge de mots (WDS) servent au découplage entre la ligne de mots (WL) à laquelle ils sont reliés et la ligne de référence de mot (WRL) et par le fait que les commutateurs de décharge de bits (BDS) servent au découplage entre une paire de lignes de bits (BL1, BL0) et la ligne commune de référence de bits (BRL).

# FIG. 1

# FIG. 2

# FIG. 3

# FIG. 4

# FIG. 5

# FIG.7

FIG. 6